# EUROPEAN PATENT APPLICATION

(11) **EP 4 586 766 A2**
(43) Date of publication of application: **16.07.2025**
(21) Application number: 25150145.8
(22) Date of filing: 03.01.2025
(51) Int. Cl.: H10D 30/01, H01L 21/265, H10D 30/66, H10D 62/10, H10D 62/40, H10D 62/832

(54) **METHOD FOR FORMING A TRENCH-GATE METAL-OXIDE-SEMICONDUCTOR FIELD-EFFECT TRANSISTOR**

(30) Priority: 12.01.2024 US 202418411230
(71) Applicant: STMicroelectronics International N.V., 1228 Plan-les-Ouates, Geneva (CH)
(72) Inventor: CAMALLERI, Cateno Marco, 95125 CATANIA (IT); SCALIA, Laura Letizia, 95037 SAN GIOVANNI LA PUNTA (CT) (IT); ZANETTI, Edoardo, 95028 VALVERDE (CT) (IT); SAGGIO, Mario Giuseppe, 95020 ACI BONACCORSI (CT) (IT)
(74) Representative: Studio Torta S.p.A.

(57) **Abstract**

A trench-gate MOSFET and method for forming a self-aligned trench bottom protective region at the bottom surface of a trench-gate in the trench-gate MOSFET are provided. The method includes forming a semiconductor source region (304) having a first conductivity type from a semiconductor body region (312) having a second conductivity type, the semiconductor body region separating the semiconductor source region from a semiconductor epitaxial layer. The method further includes etching a trench-gate opening (322a, 322b) in an exposed surface of the semiconductor source region, wherein the bottom surface of the trench-gate opening is within the semiconductor epitaxial layer. The method further includes implanting a shielding dopant having the second conductivity type by a channeling implant process. The exposed surface of the semiconductor source region is exposed to the shielding dopant during the channeling implant process, and the shielding dopant forms the trench bottom protective region (350a, 350b) at the bottom surface of the trench-gate opening.

## Description

### TECHNOLOGICAL FIELD

The present invention relates generally to trench-gate metal-oxide-semiconductor field-effect transistor (MOSFET) devices, and more particularly, to a method for forming a trench-gate MOSFET.

### BACKGROUND

A trench-gate MOSFET includes a trench-gate, vertically positioned in the semiconductor material to switch on and off electric current through the MOSFET. Certain advantages may be realized by utilizing trench-gate MOSFETs. Among other things, a trench-gate configuration enables a higher density of MOSFET devices to be manufactured on a semiconductor substrate. In addition, neighboring cells may be easily connected to work in parallel. Trench-gate MOSFETs have been shown to exhibit further advantages such as low-specific ON resistance, high power density, fast switching speed, and low switching loss. Such advantages make trench-gate MOSFETs a promising solution in semiconductor devices.

Trench-gate MOSFETs often have doped regions at the bottom of the trench gate to reduce the electrical field, protecting gate dielectric from wear out.

In some situations, it is desirable to improve or simplify the alignment of the structures.

### BRIEF SUMMARY

According to the invention, a method for forming a trench bottom protective region in a metal-oxide-semiconductor field-effect transistor device and a metal-oxide-semiconductor field-effect transistor device are provided, as defined in the appended claims.

### BRIEF DESCRIPTION OF THE DRAWINGS

For a better understanding of the present invention, an embodiment thereof is now described, purely by way of non-limiting example, with reference to the attached drawings, wherein:
FIG. 1 illustrates a cross-section view of an example trench-gate MOSFET device including a trench bottom protective region;
FIG. 2 illustrates a less desirable example method requiring a hard mask for implanting a trench bottom protective region at the bottom of a trench-gate in an trench-gate MOSFET;
FIG. 3A - FIG. 3D illustrate cross-section views of an example process for manufacturing a trench-gate MOSFET, in subsequent manufacturing steps;
FIG. 4 depicts an example channeling implantation process on an silicon carbide lattice structure; and
FIG. 5 depicts a flow chart illustrating a process for forming a self-aligned trench bottom protective region at the bottom surface of a trench-gate of a trench-gate MOSFET.

### DETAILED DESCRIPTION

As used herein, terms such as "front," "rear," "behind," "top," "vertical," "horizontal," "above," "below," "over", "under", etc. are used for explanatory purposes in the examples provided below to describe the relative positions of certain components or portions of components relative to a local reference frame of an electrical diode using an arbitrary global reference frame.

In some examples, a Cartesian (triaxial) reference system is provided. Unless otherwise stated, in general, the positive y-direction corresponds to "up," "above," or "on top." Conversely, the negative y-direction corresponds to "down," "below," "under," or "beneath."

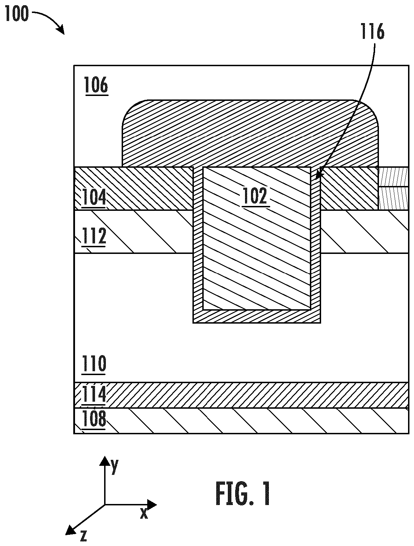

Referring now to FIG. 1, an example trench-gate MOSFET 100 is provided.

As depicted in FIG. 1, a doped semiconductor body region 112 having a first doping type (e.g., p-type) and a heavily-doped semiconductor source region 104 having a second doping type (e.g., n-type) are formed on a semiconductor epitaxial layer 110.

A trench-gate opening is etched in the surface of the semiconductor source region 104 such that the bottom surface of the trench-gate opening reaches the semiconductor epitaxial layer 110.

The trench-gate opening is coated with a dielectric layer (e.g., oxide layer 116) and is filled with a conductive material, such as polysilicon, to create a trench-gate 102.

As further depicted in FIG. 1, the semiconductor source region 104 is electrically coupled to a source conductive contact 106, while a semiconductor substrate region 114 on the surface of the semiconductor epitaxial layer 110 opposite the semiconductor body region 112 is electrically coupled to a conductive drain layer 108.

During operation, changing the voltage of the trench-gate 102 changes the electron density at the surface of the trench-gate 102. The change in electron density enables or disables the flow of current through the semiconductor body region 112, thus, allowing current to flow vertically through the trench-gate MOSFET 100, between the source conductive contact 106 and the conductive drain layer 108.

Trench-gate MOSFETs are widely used in electrical devices, particularly in high power applications. The primary advantage of a trench-gate MOSFET, such as the example trench-gate MOSFET 100 depicted in FIG. 1, is a reduction in ON resistance, as compared to a planar-gate MOSFET. The reduction in ON resistance enables the trench-gate MOSFET to operate more efficiently by reducing the voltage drop across the trench-gate MOSFET. Due to the vertical configuration of the trench-gate MOSFET, a greater density of MOSFET devices may be manufactured on an electrical device. In addition, neighboring cells may be connected to work in parallel. Trench-gate MOSFETs have further been shown to exhibit high power density, fast switching speed, and low switching loss, making trench-gate MOSFETs a common solution in semiconductor devices.

The semiconductor substrate region 114 and the semiconductor epitaxial layer 110 may comprise silicon carbide (SiC). A SiC substrate may produce a number of benefits, particularly in high-power applications. For example, SiC-based semiconductor components may dissipate heat more efficiently, be more tolerant to higher frequencies, have a low reverse leakage current and power dissipation, be more stable across a wide temperature range, have lower electromagnetic radiations, and provide other related advantages.

In some situations, the trench-gate MOSFET 100 may experience high electrical fields at the dielectric layer of the trench-gate 102. Such high electrical fields may be particularly strong between the bottom surface of the trench-gate 102 and the semiconductor epitaxial layer 110, particularly at the corners of the trench-gate 102, and at the contact surface between the semiconductor body region 112 and the trench-gate 102.

As depicted in FIG. 1, an oxide layer 116 is deposited between the trench-gate 102 and the surrounding semiconductor layers. High electric fields in the oxide layer 116 may cause dielectric breakdown in the oxide layer 116. The breakdown of the oxide layer 116 may have adverse effects on the performance of the trench-gate MOSFET 100.

Due to the increased electric field in the oxide layer 116 at the bottom surface of the trench-gate 102, many trench-gate MOSFET devices 100 require a shielding region disposed at the bottom surface of the trench-gate 102. The shielding region protects the oxide layer 116 from excessive and damaging electric fields. In addition, the shielding region acts to shield the semiconductor body region 112 from the high potential difference that may exist between the conductive drain layer 108 and the source conductive contact 106. Thus, the shielding region may prevent excess depletion in the body layer, enhancing the blocking capability of the body layer during operation.

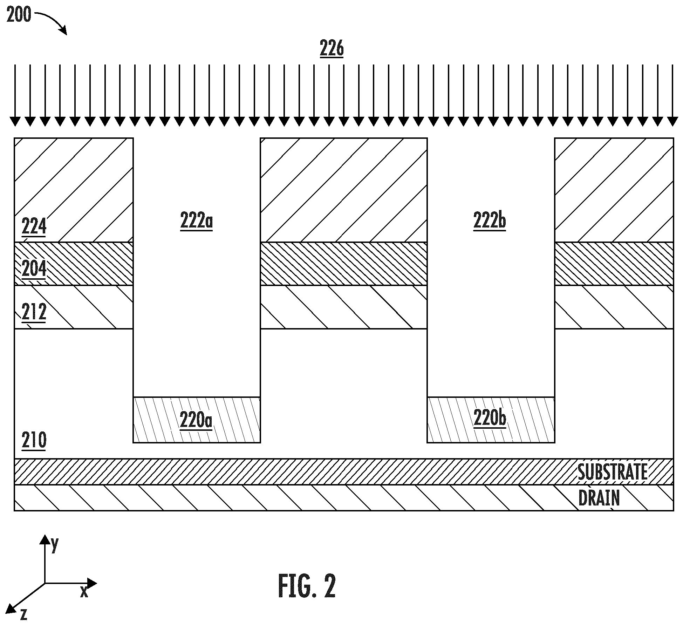

Referring now to FIG. 2, in a less desirable process, a shielding region 220a, 220b may be formed at the bottom surface of a trench-gate opening 222a, 222b by protecting the top surface of the semiconductor device 200 with a hard mask 224 and utilizing a high-energy implantation process 226 for ion implantation.

As depicted in FIG. 2, the hard mask 224 is deposited on the top layer of the semiconductor device 200, including the semiconductor source region 204. In order to create the trench-gate of a trench-gate MOSFET, the trench-gate opening 222a, 222b is etched through the hard mask 224, the semiconductor source region 204, the semiconductor body region 212, and into the semiconductor epitaxial layer 210. The hard mask 224 provides a protective coating to the components of the semiconductor device 200 (e.g., the semiconductor source region 204) during the damaging, high-energy implantation process 226.

The less desirable approach of utilizing a high-energy implantation process 226 to form the shielding region 220a, 220b at the bottom surface of the trench-gate opening 222a, 222b may have a number of drawbacks. During the high-energy implantation process 226, dopants of a particular species (e.g., Arsenic, Phosphorus, Boron, etc.) are accelerated in a high-energy beam. In some embodiments, the energy used to accelerate the dopants may be between 1000 kiloelectronvolts and 3000 kiloelectronvolts. The high-energy ion beam is directed at the surface of the semiconductor device 200. In the portions of the semiconductor device 200 that are not protected by a protective coating (e.g., hard mask 224), such as the bottom surface of the trench-gate opening 222a, 222b, the accelerated ions in the high-energy beam penetrate the surface of the semiconductor.

In addition to the high energy (1000 - 3000 keV) associated with the high-energy implantation process 226, the high-energy implant process may also be performed at high temperatures (e.g., between 300 degrees and 500 degrees Celsius. The high-energy of the accelerated ions and the high temperatures may be damaging to any exposed surfaces of the semiconductor device 200. In addition, the high-energy implantation process 226 may penetrate the side walls of the trench-gate opening 222a, 222b. Such lateral straggling of the dopant may adversely affect the performance of the semiconductor device 200. Lateral straggling is particularly problematic in instances in which the size of the semiconductor device 200 is reduced. Thus, a hard mask 224 is deposited on the surfaces of the semiconductor device 200 to protect the electrical properties of the components of the semiconductor device 200 from the accelerated ions in the high-energy implantation process 226.

Deposition and removal of the hard mask 224 may further cause damage to the surfaces of the semiconductor device 200 in contact with the hard mask 224. For example, the hard mask 224 may cause warpage in the surface of the semiconductor source region 204 and other regions of the semiconductor device 200. Warpage in the semiconductor source region 204 caused by the hard mask 224 may have numerous adverse effects on the performance of the semiconductor device 200. For example, warpage in the semiconductor source region 204 results in non-uniform distribution of implanted ions, particular in an instance in which a channeling implant is used.

Further, deposition and removal of the hard mask may cause irreparable damage to the lattice structure of the contacting regions of the semiconductor device 200, further adversely affecting the performance of the semiconductor device 200. The deposition and removal of the hard mask 224 may additionally alter the electrical properties of the surface of the semiconductor device 200. Alteration of the electrical properties of the components of the semiconductor device may further adversely affect the performance of the semiconductor device 200.

In addition, use of a hard mask 224 may limit the critical dimensions of the trench gate. For example, a hard mask 224 may be etched to form openings in the hard mask within which the trench-gate openings may be formed. A minimum size of openings in a hard mask may be limited based on hard mask etching accuracy. Thus, the minimum size of trench-gate openings may be limited. Such properties may be problematic as manufactures seek to further reduce the sizes of trench-gate MOSFETs, and thus the size of the trench-gates comprising trench-gate MOSFETS.

The following description regards various techniques to form a trench bottom protective region at the bottom surface of a trench-gate opening of a trench-gate MOSFET. For example, in some embodiments, exposed surfaces of the trench-gate MOSFET may be intentionally damaged resulting in a broken lattice structure of the semiconductor structure (e.g., silicon carbide). The broken lattice structure may minimize the penetration of implanted ions during the ion implantation process, particularly when compared with an undamaged semiconductor surface comprising an intact lattice structure.

A number of techniques may be utilized to intentionally damage the exposed surfaces of the semiconductor device. For example, regions of the semiconductor device may be heavily doped with ions. The ion implantation process associated with doping, particularly at high concentrations, may create significant damage to the lattice structure of the doped regions. Thus, semiconductor regions, such as the semiconductor source region and the body contact region may be heavily doped in order to protect such surfaces from significant penetration during the implantation process associated with the formation of the trench bottom protective region. After the ion implantation process, annealing processes may be performed to at least partially recover electrical contacts between the various regions, while the doped regions remain intentionally damaged.

In addition, a low-energy channeling implantation process may be used for the formation of the trench bottom protective region. A channeling implantation process leverages the architecture of the target semiconductor to maximize penetration of implantation at a low energy. Such channeling implantation may accelerate ions toward the target surface (e.g., bottom surface of the trench-gate opening) at a specific rotation and angle as measure from the normal of the target surface (implant angle with respect to a normal to the surface of the semiconductor device 300). The rotation and angle are selected to maximize the penetration of the accelerated ions into the target surface. For example, by aligning the acceleration of the ions with the lattice structure of the semiconductor, the accelerated ions may experience fewer collisions and penetrate deeper into the lattice structure with lower energy. Further, the rotation and angle of the channeling implantation process may be selected to reduce impact with the nuclei of the crystal structure. The reduction in impact with the nuclei of the crystal structure reduces the lateral straggle, or penetration of ions into the side walls, of the trench gate opening.

At the same time, the penetration of low energy implant ions into a damaged lattice structure, such as those intentionally damaged regions, is limited. The result is deep penetration into the bottom surface of the trench-gate opening and minimal penetration into the intentionally damaged surfaces, such as the semiconductor source region.

Further, the low-energy channeling implantation process may be performed at a lower temperatures, for example, at or near room temperature. Reduction of temperatures during the implantation process enable the use of simpler, less expensive equipment during the semiconductor manufacturing process.

As a result of the above, the manufacturing process associated with the creation of a trench bottom protective region at the bottom surface of a trench-gate opening on a trench-gate MOSFET, is greatly improved. For example, leveraging intentionally damaged regions, the trench bottom protective region may be formed at the bottom surface of the trench-gate opening without the need of a hard mask.

Removing the need for a hard mask simplifies difficult steps associated with alignment, depositing, and removal of the hard mask layer.

In addition, the performance of the trench-gate MOSFETs created utilizing the herein described process may be greatly improved. Damage to the surface of the electrical components due to depositing and removing of the hard mask may be avoided. Avoidance of such damage may greatly improve the reliability and performance of the trench-gate MOSFET.

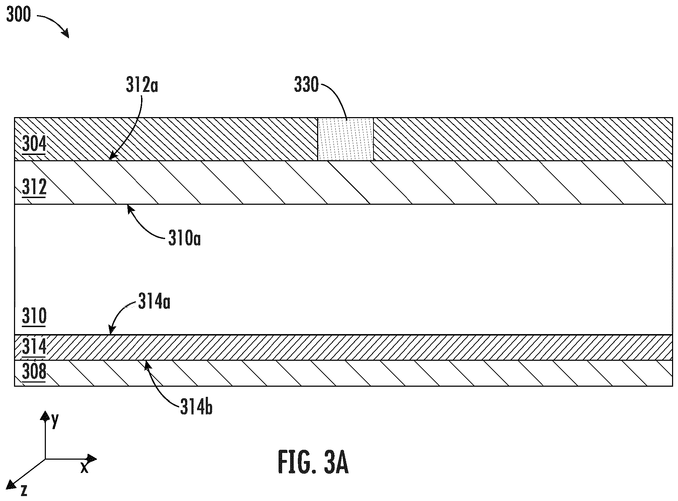

Referring now to FIG. 3A - 3D, an example process for forming a trench bottom protective region at the bottom surface of a trench-gate MOSFET is provided.

Referring now to FIG. 3A, an example semiconductor device 300 during the formation of a trench bottom protective region on a bottom surface of a trench-gate opening in a trench-gate MOSFET device is depicted.

As depicted in FIG. 3A, the example semiconductor device 300 includes a semiconductor substrate layer 314 having a top surface 314a and a bottom surface 314b. A semiconductor epitaxial layer 310 is formed on the top surface 314a and a conductive drain layer 308 is formed on the bottom surface 314b opposite the semiconductor epitaxial layer 310.

As further depicted in FIG. 3A, a semiconductor body region 312 is formed at the top surface 310a of the semiconductor epitaxial layer 310.

The semiconductor source region 304 is further formed on the top surface 312a of the semiconductor body region 312.

Within the semiconductor source region 304 a body contact region 330 may be formed, creating an electrical contact with the semiconductor body region 312 through the semiconductor source region 304.

The semiconductor substrate layer 314 may be any semiconductor material serving as the base layer of a semiconductor component (e.g., a trench-gate MOSFET) and may comprise Silicon, Germanium, Gallium Arsenide, Gallium Nitride, silicon carbide (SiC), or other similar semiconductor material.

SiC for semiconductor substrate layer 314 may offer a number of advantages in high-power applications. For example, SiC-based semiconductor components may dissipate heat more efficiently, be more tolerant at higher frequencies, have a low reverse leakage current and power dissipation, be more stable across a wide temperature range, have lower electromagnetic radiations, and provide other related advantages.

Semiconductor substrate layer 314 may be doped by a first dopant type to create a semiconductor having a particular conductivity type. A dopant may be any impurity deliberately added to a semiconductor to modify the electrical conductivity of the semiconductor. Adding a dopant to the semiconductor substrate layer 314 with extra valence electrons creates a semiconductor with an n-type doping or an n-doped semiconductor. Dopants having extra valence electrons may include Phosphorus, Arsenic, Antimony, etc. Adding a dopant to the semiconductor substrate layer 314 with a shortage of valence electrons creates a semiconductor with a p-type doping or a p-doped semiconductor. Dopants having a shortage of valence electrons may include Boron, Aluminum, Gallium, etc. As shown in FIG. 3A, the semiconductor substrate layer 314 of the example semiconductor device 300 is an n-typed semiconductor substrate layer 314.

The doping concentration of the semiconductor substrate layer 314 may be higher than the doping concentration of the semiconductor epitaxial layer 310.

Semiconductor substrate layer 314 may serve as a base layer for epitaxial growth of additional semiconductor material. Epitaxial growth may be utilized to grow additional crystal layers on the semiconductor substrate layer 314, such as the semiconductor epitaxial layer 310.

As further depicted in FIG. 3A, the semiconductor epitaxial layer 310 is arranged on the top surface 314a of the semiconductor substrate layer 314. Semiconductor epitaxial layer 310 may be any semiconductor material configured to enable the flow of current from the semiconductor source region 304 to the conductive drain layer 308 as a result of the drift of majority carriers. The semiconductor epitaxial layer 310 enables the flow of current from the semiconductor source region 304 to the conductive drain layer 308 when the gate voltage at the trench-gate of the trench-gate MOSFET exceeds a threshold. Further, the semiconductor epitaxial layer 310 may block or limit the flow of current in the reverse direction, e.g., from the conductive drain layer 308 to the semiconductor source region 304.

Semiconductor epitaxial layer 310 is of the same dopant type as the semiconductor substrate layer 314, e.g., an n-type semiconductor, but has a different doping concentration. For example, the semiconductor epitaxial layer 310 may have a lower doping concentration than the semiconductor substrate layer 314.

As further depicted in FIG. 3A, semiconductor body region 312 is positioned between the semiconductor source region 304 and the conductive drain layer 308 such that the flow of current between the semiconductor source region 304 and the conductive drain layer 308 is blocked in an instance in which the voltage at the trench-gate does not exceed the threshold voltage. The semiconductor body region 312 may be doped by a dopant type opposite the semiconductor source region 304 and the semiconductor epitaxial layer 310.

For example, the semiconductor body region 312 is a p-type semiconductor. In particular, the semiconductor body doping concentration may be between 1×10¹⁷ ions per cm³ and 1×10²² ions per cm³; more preferably between 1.5×10¹⁷ ions per cm3 and 1.5×10²¹ ions per cm3; most preferably between 1×10¹⁸ ions per cm³ and 1×10²¹ ions per cm³.

Semiconductor source region 304 may be any conductive material through which current enters the semiconductor device 300, or equivalently, electrons leave the semiconductor device 300. In FIG. 3A, semiconductor source region 304 is disposed atop the semiconductor body region 312 and provides a conductive path from an external contact point through the semiconductor body region 312 to the semiconductor epitaxial layer 310.

The semiconductor source region 304 may form a PN junction with the semiconductor body region 312.

As described herein, the semiconductor source region 304 may comprise a heavily-doped semiconductor material of the same conductivity type as the semiconductor epitaxial layer 310 (e.g., N+) and formed using an ion implantation process. The ion implantation process may be any ion implantation process in which the surface of the semiconductor device 300 is intentionally damaged. For example, ions may be accelerated toward the surface of the semiconductor body region 312 to change the electrical properties thereof. The accelerated ions damage the lattice structure of the semiconductor base and lodge within the semiconductor material. The damaged lattice structure increases the difficulty of subsequent implantation processes (e.g., the formation of the trench bottom protective region) from penetrating the semiconductor source region 304. Particularly, ion implantation processes relying on channeling through the lattice structure of the semiconductor material, are unable to penetrate deep into the semiconductor material when compared with channeling implantation in a semiconductor material with the lattice structure intact. For example, ions utilized to create an n-type doping in the semiconductor material include phosphorus, arsenic, and antimony, among others.

The body contact region 330 has the same doping type as the semiconductor body region 312 and is positioned to enable an electrical contact to be made with the semiconductor body region 312 from an external surface of the semiconductor device 300.

The semiconductor body contact region 330 may have a different doping concentration (body contact doping concentration) from the semiconductor body region 312. For example, the semiconductor body contact region 330 may have a higher doping concentration than the semiconductor body region 312. In some embodiments, the body contact doping concentration may be between 1×10¹⁷ ions per cm³ and 1×10²² ions per cm³; more preferably between 1.5×10¹⁷ ions per cm³ and 1.5×10²¹ ions per cm³; most preferably between 1×10¹⁸ ions per cm³ and 1×10²¹ ions per cm³.

The semiconductor body contact region 330 may enable a voltage to be applied to the semiconductor body region 312, changing the electrical properties of the semiconductor device 300, for example, changing the barrier voltage of a transistor device.

Semiconductor body contact region 330 may be formed using an ion implantation process in the semiconductor source region 304.

The ion implantation process may be any ion implantation process in which the surface of the semiconductor body region 312 is intentionally damaged. For example, ions may be accelerated toward the surface of the semiconductor device 300 to change the electrical properties of the semiconductor source region 304 where the body contact region 330 is to be formed. The accelerated ions damage the lattice structure of the semiconductor base and lodge within the semiconductor material. The damaged lattice structure increases the difficulty of subsequent implantation processes (e.g., the formation of the trench bottom protective region) from penetrating the semiconductor body contact region 330. Particularly, ion implantation processes relying on channeling through the lattice structure of the semiconductor material, are unable to penetrate deep into the semiconductor material when compared with channeling implantation in a semiconductor material with the lattice structure intact. For example, ions utilized to create a p-type doping in the semiconductor material include boron, indium, aluminum, gallium, and thallium, among others.

Conductive drain layer 308 may be any conductive material (e.g., back-side metal) through which current exits the semiconductor device 300, or equivalently, electrons enter the semiconductor device 300. For example, the conductive drain layer 308 may comprise a metal, or combination of metals, such as molybdenum, platinum, chromium, tungsten, nickel, or other similar conductive material. In FIG. 3A, the conductive drain layer 308 may be disposed below the semiconductor substrate layer 314, adjacent to the bottom surface thereof. The conductive drain layer 308 may be shared by one or more neighboring trench-gate MOSFET devices. Sharing the conductive drain layer 308 may enable a greater concentration of trench-gate MOSFET devices in a given area.

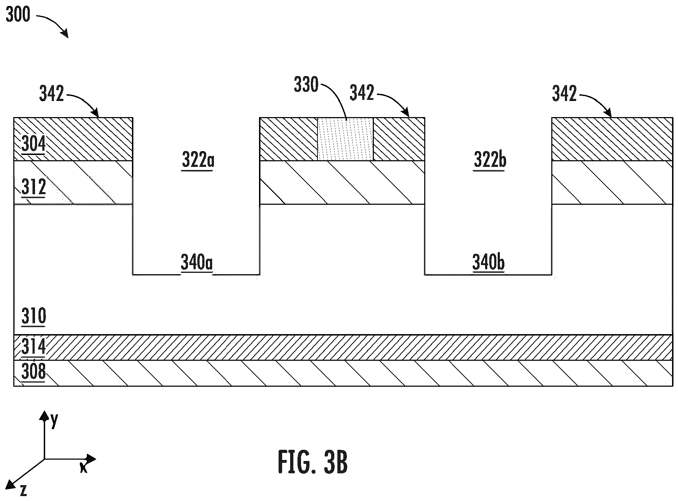

FIG. 3B, in semiconductor device 300 trench-gate openings 322a, 322b having a bottom surface 340a, 340b in the semiconductor epitaxial layer 310 are formed.

A trench-gate opening 322a, 322b is any channel, basin, cavity, hole, indentation, groove, or other trench formed in a top surface 342 of the semiconductor device 300 and configured to receive a conductive material, such as polysilicon, to form a gate structure of a vertically oriented MOSFET

Trench-gate openings 322a, 322b may be etched in the surface of the semiconductor device 300 using standard etching techniques, such as dry etching. Dry etching techniques may include depositing a protective layer on the top surface 342 of the semiconductor device 300, such as photoresist, and patterning the protective layer to expose portions of the semiconductor device 300 to be etched. Dry etching techniques may include chemical dry etching, such as, plasma dry etching.

As further depicted in FIG. 3B, the trench-gate openings 322a, 322b defined in the semiconductor device 300 are etched through the semiconductor source region 304 and the semiconductor body region 312 such that the respective bottom surfaces 340a, 340b of the trench-gate openings 322a, 322b are formed in the semiconductor epitaxial layer 310.

The bottom surfaces 340a, 340b formed during the etching process are configured to maintain the lattice structure of the underlying semiconductor material. For example, when the semiconductor epitaxial layer comprises a silicon carbide semiconductor material, the lattice structure of the silicon carbide remains intact at the bottom surface 340a, 340b of the trench-gate opening 322a, 322b at the completion of the etching process. The trench-gate opening 322a, 322b formed through the semiconductor source region 304 and the semiconductor body region 312 and into the semiconductor epitaxial layer 310 creates an opening for a vertical structure to facilitate the transfer of current from the semiconductor source region 304 to the conductive drain layer 308.

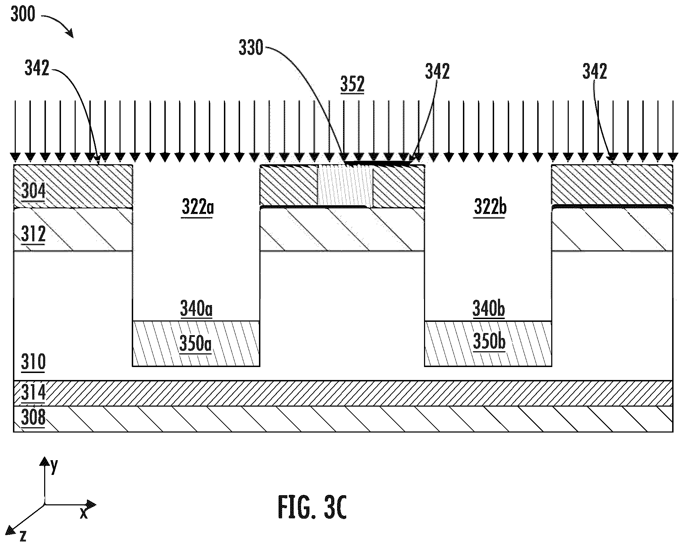

Referring now to FIG. 3C, semiconductor device 300 has trench bottom protective regions 350a, 350b formed on the bottom surfaces 340a, 340b of the trench-gate openings 322a, 322b of the semiconductor device 300.

Trench bottom protective regions 350a are here formed by a low energy channeling implantation process 352. The channeling implantation process 352 is performed without the protection of a hard mask which may cause undesirable damage to the surface of the semiconductor source region 304 and the body contact region 330 during deposition and removal.

As described in relation to FIG. 3A, the semiconductor source region 304 and the body contact region 330 are formed using intentionally damaging ion implantation processes. Due to the intentionally damaging ion implantation processes, the lattice structure at the semiconductor source region 304 and the body contact region 330 is damaged. Further, as described in relation to FIG. 3B, the etching process forming the trench-gate openings 322a, 322b expose a portion of the semiconductor epitaxial layer 310 at the bottom surface 340a, 340b of the trench-gate opening 322a, 322b comprising intact lattice structures.

The penetration depth of ions during ion implantation may be greatly affected by the state of the lattice structure of the targeted semiconductor surface. Since the lattice structure of the targeted semiconductor surface is heavily damaged on top surface 342, the penetration depth of the accelerated ions may be shallower than the penetration depth of the accelerated ions where the lattice structure of the targeted semiconductor surface is intact (e.g., bottom surface 340a, 340b). Thus, semiconductor device 300 having both heavily damaged semiconductor surfaces (in particular, top surface 342) and semiconductor surfaces with the lattice structure intact (e.g., bottom surface 340a, 340b) may experience significantly different ion penetration depths.

As depicted in FIG. 3C, intentionally damaged semiconductor surfaces may be leveraged to form self-aligned trench bottom protective regions 350a, 350b at the bottom surface 340a, 340b of the trench-gate openings 322a, 322b, without adversely affecting the electrical properties of the exposed regions on the top surface 342 of the semiconductor device 300, such as the semiconductor source region 304. In particular, when the intentionally damaged top surface 342 of the semiconductor device 300 and the intact bottom surface 340a, 340b of the trench-gate opening 322a, 322b are exposed to an ion implantation process, the depth of the penetration of ions at the bottom surface 340a, 340b of the trench-gate opening 322a, 322b is greater than the depth of the penetration of ions at the top surface 342.

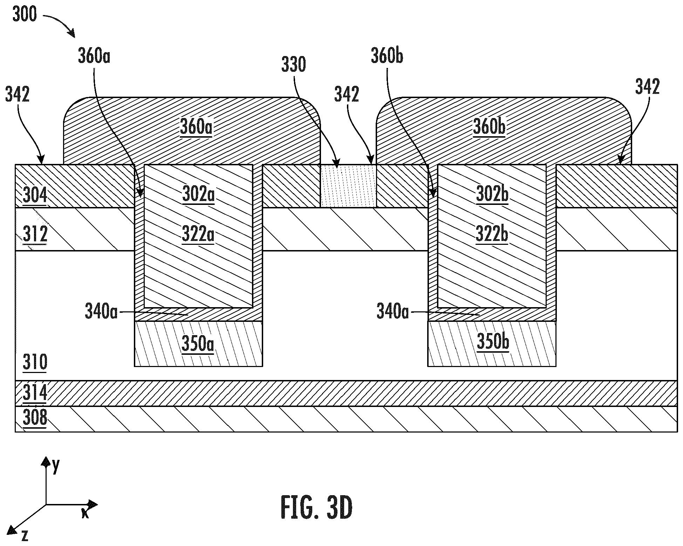

The depth of penetration of ions at the bottom surface 340a, 340b of the trench-gate opening 322a, 322b forms trench bottom protective regions 350a, 350b providing sufficient protection to the trench-gate oxide layer (e.g., oxide layer 360a, 360b depicted in FIG. 3D, as discussed later on) and semiconductor body region 312, while preserving the electrical properties of the semiconductor source region 304 and the body contact region 330.

Channeling implantation process 352 may be performed such that the accelerated ions encounter the target surface at an implant angle relative to the normal of the target surface, such that the target angle is aligned with openings in the lattice structure of the semiconductor material of the target surface.

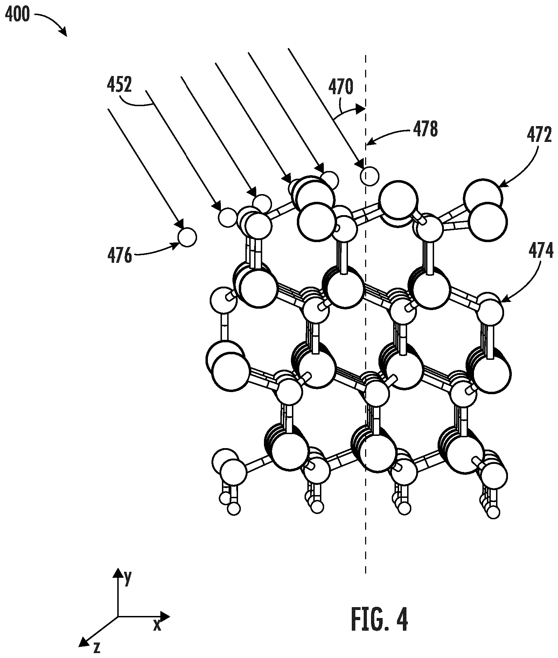

An example channeling implantation process 352 for a silicon carbide semiconductor material is described further in relation to FIG. 4.

Utilizing a low energy channeling implantation process 352 ensures sufficient penetration of ions at the bottom surface 340a, 340b of the trench-gate opening 322a, 322b while penetration in the intentionally damaged regions of the top surface 342 is negligible. The low energy channeling implantation process 352 may utilize a low ion energy to accelerate the ions toward the surfaces of the semiconductor device 300. For example, the low ion energy is between 30 kiloelectronvolts and 3000 kiloelectronvolts; more preferably between 30 kiloelectronvolts and 2000 kiloelectronvolts; most preferably between 30 kiloelectronvolts and 1000 kiloelectronvolts.

In addition, a thermal annealing process may be performed after each implantation process during semiconductor production. The performance of an annealing process after each implantation process, as opposed to one annealing process after all implants, enables at least partial recovery of electrical contacts between the newly doped region and the adjacent regions of the semiconductor device. However, the doped region remains intentionally damaged.

By utilizing the channeling implantation process 352 to maximize the penetration depth of accelerated ions in undamaged regions of the semiconductor lattice structure, it is possible to avoid the high temperatures required during a high energy implantation process. For example, the temperature during the channeling implantation process 352 may be at or near room temperature, e.g., between 25 degrees and 30 degrees Celsius; more preferably between 23 degrees and 24 degrees Celsius; most preferably between 20 degrees and 22 degrees Celsius.

Reduction in the operating temperature during the channeling implantation process 352 may enable the use of simpler, less expensive equipment. In addition, in an instance in which hard masks may be desired, the channeling implantation process 352 may enable the use of thinner hard masks for better control over the distribution of the implanted ions.

Referring now to FIG. 3D, semiconductor device 300 having vertically aligned trench-gates 302a, 302b is shown.

As depicted in FIG. 3D, an oxide layer 360a, 360b is deposited on the interior surfaces of the trench-gate opening 322a, 322b, forming a barrier between a trench-gate 302a, 302b and the semiconductor source region 304, the semiconductor body region 312, and the semiconductor epitaxial layer 310 of the semiconductor device 300. The oxide layer 360a, 360b is further deposited on the top surface of the trench-gates 302a, 302b, isolating the trench gate from external layers such as source conductive contacts and body contact region electrical contacts.

As depicted in FIG. 3D, protective oxide layer 360a, 360b is deposited also on the top surfaces of the trench-gate opening 322a, 322b to form a dielectric layer between the layers of the semiconductor device 300 and the trench-gate 302a, 302b and allow an electric field between the trench-gate 302a, 302b and the semiconductor source region 304, the semiconductor body region 312, and the semiconductor epitaxial layer 310 to be optimized. The formation of an electric field establishes a conductive channel between semiconductor source region 304 and the semiconductor epitaxial layer 310 through the semiconductor body region 312.

Overstressing the oxide layer 360a, 360b often leads to the failure of semiconductor devices 300, such as MOSFET devices. Failure due to overstressed oxide layers 360a, 360b is especially prevalent in high power applications. In an instance in which the semiconductor device 300 is in a blocking state, the electric field at the bottom surface 340a, 340b of the trench-gate opening 322a, 322b may reach damaging levels. Sustained electric fields at the bottom surface 340a, 340b of the trench-gate opening 322a, 322b may break down the oxide layers 360a, 360b resulting in failed performance of the semiconductor device 300.

As depicted in FIG. 3D, the trench bottom protective region 350a, 350b is formed in the example semiconductor device 300 to reduce the electric field at the bottom surface 340a, 340b of the trench-gate opening 322a, 322b particularly in high power applications. In an instance in which the semiconductor device 300 is in a blocking state, electric field may collect at the bottom surface 340a, 340b of the trench-gate opening 322a, 322b. Such electric field may cause premature breakdown of the oxide layer 360a, 360b at the bottom surface 340a, 340b of the trench-gate opening 322a, 322b.

The trench bottom protective region 350a, 350b may prolong the effective operation of the semiconductor device 300, particularly in high power applications.

Referring now to FIG. 4, an example channeling implantation process 452 on a silicon carbide lattice structure 400 is shown.

As depicted in FIG. 4, the example channeling implantation process 452 includes the acceleration of ions 476 toward a silicon carbide surface comprising silicon atoms 472 and carbon atoms 474 having an intact silicon carbide lattice structure 400. The ions 476 are accelerated toward the silicon carbide lattice structure 400 at an implant angle 470 with respect to a normal 478 to the surface of the semiconductor such that the ions 476 penetrate the silicon carbide lattice structure 400 through the openings in the silicon carbide lattice structure 400.

As depicted in FIG. 4, the silicon atoms 472 and the carbon atoms 474 of silicon carbide are organized in the lattice structure 400 with defined openings and channels. The channeling implantation process 452 leverages knowledge of the silicon carbide lattice structure 400 to accelerate ions 476 toward the lattice structure 400 such that interference with the silicon atoms 472 and carbon atoms 474 is minimized.

For example, on a silicon carbide semiconductor with a cut-of angle at or near 4 degrees, the implant angle 470 may be between 3 degrees and 5 degrees; more preferably between 3.25 degrees and 4.75 degrees; most preferably between 3.5 degrees and 4.5 degrees.

By aligning the accelerated ions 476 with the openings in the silicon carbide lattice structure 400, a low energy channeling implantation process 452 may be utilized. Such a channeling implantation process 452 ensures penetration of ions in intact lattice structures to be sufficient for trench bottom protection while penetration in surfaces with intentionally damaged lattice structures is negligible.

The implant angle 470 may be dependent on the manufacture of the semiconductor wafer. Thus, the implant angle 470 may be dependent on the semiconductor type (e.g., silicon carbide, silicon, etc.) and the cut-off angle of the semiconductor wafer. The varying conditions of manufacture may create a channeling angle tolerance. A channeling angle tolerance may be a range of implant angles 470 for which the channeling implantation process 452 may be configured to operate and still obtain sufficient ion implantation depth.

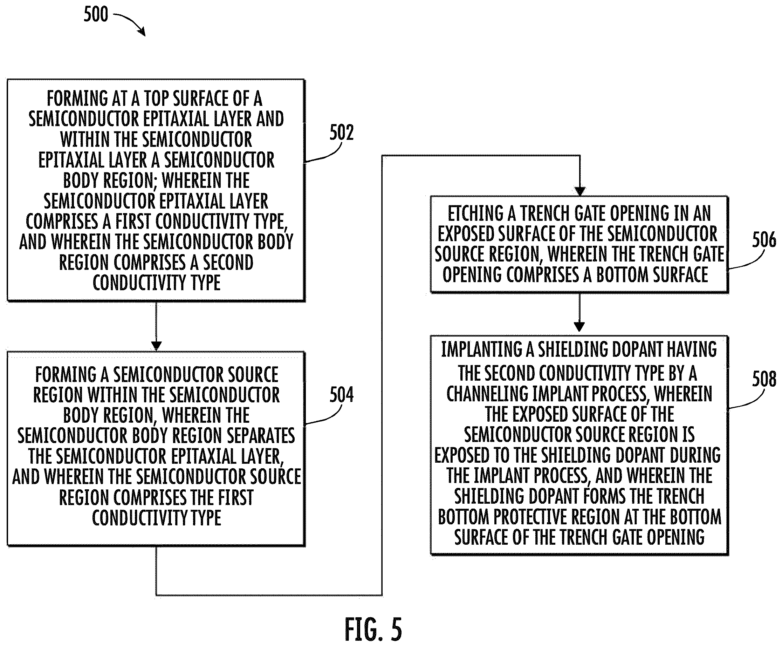

Referring now to FIG. 5, an example process 500 for forming a self-aligned trench bottom protective region (e.g., trench bottom protective region 350a, 350b) at the bottom surface of the trench-gate (e.g., trench-gate 302a, 302b) of the trench-gate MOSFET is provided.

At block 502, semiconductor body region (e.g., semiconductor body region 312 of FIG. 3A) is formed at a top surface of a semiconductor epitaxial layer (e.g., semiconductor epitaxial layer 310) and within the semiconductor epitaxial layer; wherein the semiconductor epitaxial layer comprises a first conductivity type, and wherein the semiconductor body region comprises a second conductivity type to create a PN junction. The semiconductor body region may be a doped p-type semiconductor and the semiconductor epitaxial layer may be a doped n-type semiconductor.

At block 504, a semiconductor source region (e.g., semiconductor source region 304) is formed within the semiconductor body region (e.g., 312), wherein the semiconductor source region comprises the first conductivity type.

The semiconductor source region may be formed using ion implantation processes intended to intentionally damage the lattice structure of the semiconductor source region. The semiconductor source region comprises a doped semiconductor having a heavily doped semiconductor doping concentration. For example, the semiconductor source region may comprise an n-type doping type.

A semiconductor body contact region (e.g., 330) may also formed within the semiconductor body region (e.g., 312). Semiconductor body be formed using an ion implantation process.

Semiconductor body contact region 330 may be formed after formation of the semiconductor source region. Semiconductor body contact region 330 may be formed by an ion implantation process so that the semiconductor body contact region 330 has a higher doping concentration than semiconductor body region 312.At block 506, a trench-gate opening (e.g., trench-gate openings 322a, 322b) is etched in an exposed surface (e.g., top surface 342) of the semiconductor source region to form a bottom surface (e.g., bottom surface 340a, 340b) at the semiconductor epitaxial layer.

The etching process exposes the bottom surface of the trench-gate opening, wherein the lattice structure of the semiconductor epitaxial layer comprising the bottom surface is intact.

At block 508, a shielding dopant having the second conductivity type is implanted by a channeling implant process (e.g., channeling implantation process 352) to form the trench bottom protective region of the trench-gate opening.

The exposed surface of the semiconductor source region is also exposed to the shielding dopant during the implant process.

As described herein, the channeling implant process forming the trench bottom protective region of the trench-gate opening 322a, 322b is formed without the use of a hard mask to protect the top surface structures, such as the semiconductor source region and the body contact region. Instead, these structures are protected by the intentionally damaged surfaces of these regions, such that the penetration of accelerated ions is minimized at the top surface structures.

As discussed above, implant may be carried out with an implant angle of the channeling implantation process which is aligned with the lattice structure of the semiconductor material to maximize penetration of the shielding dopant into the bottom surface of the trench bottom opening, forming a trench bottom protective region at the bottom surface of the trench bottom opening.

Summarizing, the present disclosure regards a method and a device as defined in the following examples.

Example 1. A method for forming a trench bottom protective region in a metal-oxide-semiconductor field-effect transistor (MOSFET) device, the method comprising:
forming at a top surface of a semiconductor epitaxial layer and within the semiconductor epitaxial layer a semiconductor body region;
   wherein the semiconductor epitaxial layer comprises a first conductivity type, and
   wherein the semiconductor body region comprises a second conductivity type;
forming a semiconductor source region within the semiconductor body region,
wherein the semiconductor body region separates the semiconductor source region from the semiconductor epitaxial layer, and
wherein the semiconductor source region comprises the first conductivity type;
   etching a trench-gate opening in an exposed surface of the semiconductor source region, wherein the trench-gate opening comprises a bottom surface, and
   wherein the bottom surface comprises the semiconductor epitaxial layer; and implanting a shielding dopant having the second conductivity type by a channeling implant process,
wherein the exposed surface of the semiconductor source region is exposed to the shielding dopant during the channeling implant process, and

Example 2. The method of Example 1, wherein the channeling implant process accelerates the shielding dopant toward the MOSFET device at a low ion energy.

Example 3. The method of Example 2, wherein the low ion energy is between 30 kiloelectronvolts and 3000 kiloelectronvolts.

Example 4. The method of Example 1, wherein the channeling implant process accelerates the shielding dopant toward the MOSFET device at an implant angle, and
wherein the implant angle is measured relative to a direction normal to a surface of the MOSFET device.

Example 5. The method of Example 4, wherein the implant angle is between 3.5 degrees and 4.5 degrees.

Example 6. The method of Example 1, further comprising:
forming a body contact region having the second conductivity type within the semiconductor source region,
wherein the body contact region is electrically coupled with the semiconductor body region.

Example 7. The method of Example 6, wherein the body contact region is doped at a body contact doping concentration.

Example 8. The method of Example 7, wherein the semiconductor body region is doped at a semiconductor body concentration.

Example 9. The method of Example 8, wherein the body contact doping concentration is greater than the semiconductor body concentration.

Example 10. The method of Example 1, wherein the first conductivity type is an n-type semiconductor.

Example 11. The method of Example 1, wherein the second conductivity type is a p-type semiconductor.

Example 12. The method of Example 1, wherein the semiconductor epitaxial layer is doped at a first doping concentration.

Example 13. The method of Example 12, wherein the semiconductor source region is doped at a second doping concentration.

Example 14. The method of Example 13, wherein the first doping concentration is less than the second doping concentration.

Example 15. The method of Example 1, wherein the semiconductor source region is formed using an ion implantation process.

Example 16. The method of Example 15, wherein a source region lattice structure of the semiconductor source region is intentionally damaged during the ion implantation process.

Example 17. The method of Example 6, wherein the body contact region is formed using an ion implantation process.

Example 18. The method of Example 17, wherein a body contact region lattice structure of the body contact region is intentionally damaged during the ion implantation process.

Example 19. A trench-gate MOSFET device, comprising:
a semiconductor body region comprising a first conductivity type;
a semiconductor source region formed at a top surface of the semiconductor body region and comprising a second conductivity type;
a semiconductor epitaxial layer comprising the second conductivity type, wherein the semiconductor body region is separated from the semiconductor source region by the semiconductor body region;
a trench-gate opening etched in an exposed surface of the semiconductor source region,
wherein the trench-gate opening comprises a bottom surface, and
wherein the bottom surface comprises the semiconductor epitaxial layer; and
a trench bottom protective region formed in the semiconductor epitaxial layer at the bottom surface of the trench-gate opening, wherein the trench-gate opening is formed by:
   implanting a shielding dopant having the second conductivity type by a channeling implant process,
   wherein the exposed surface of the semiconductor source region is exposed to the shielding dopant during the channeling implant process, and
   wherein the shielding dopant forms the trench bottom protective region at the bottom surface of the trench-gate opening.

Example 20. A trench-gate MOSFET device product-by-process, produced by a method comprising:
forming at a top surface of a semiconductor epitaxial layer and within the semiconductor epitaxial layer a semiconductor body region;
   wherein the semiconductor epitaxial layer comprises a first conductivity type, and
wherein the semiconductor body region comprises a second conductivity type;
forming a semiconductor source region within the semiconductor body region,
wherein the semiconductor body region separates the semiconductor source region from the semiconductor epitaxial layer, and
wherein the semiconductor source region comprises the first conductivity type;
etching a trench-gate opening in an exposed surface of the semiconductor source region,
wherein the trench-gate opening comprises a bottom surface, and
wherein the bottom surface comprises the semiconductor epitaxial layer; and
implanting a shielding dopant having the second conductivity type by a channeling implant process,
wherein the exposed surface of the semiconductor source region is exposed to the shielding dopant during the implant process, and
wherein the shielding dopant forms the trench bottom protective region at the bottom surface of the trench-gate opening.

Finally, it is clear that modifications and variations may be made to the method and device described and illustrated herein without departing from the scope of the present invention, as defined in the attached claims.

## Claims

1. A method for forming a metal-oxide-semiconductor field-effect transistor (MOSFET) device, the method comprising:
forming a semiconductor body region (312) on a surface (310a) of a semiconductor epitaxial layer (310), wherein the semiconductor epitaxial layer has a first conductivity type, and the semiconductor body region has a second conductivity type;
forming a semiconductor source region (304) on the semiconductor body region (312), wherein the semiconductor body region (312) separates the semiconductor source region (304) from the semiconductor epitaxial layer (310), and the semiconductor source region has the first conductivity type;
etching a trench-gate opening (322a, 322b) in an exposed surface of the semiconductor source region (304), wherein the trench-gate opening has a bottom surface (340a, 340b), and the bottom surface extends in the semiconductor epitaxial layer; and
implanting a shielding dopant having the second conductivity type by a channeling implant process (352), wherein the exposed surface of the semiconductor source region is exposed to the shielding dopant during the channeling implant process, and wherein the shielding dopant forms a trench bottom protective region (350a, 350b) at the bottom surface of the trench-gate opening.

2. The method of claim 1, wherein the channeling implant process accelerates the shielding dopant toward the MOSFET device at a low ion energy.

3. The method of claim 2, wherein the low ion energy is between 30 kiloelectronvolts and 3000 kiloelectronvolts.

4. The method of any of the preceding claims, wherein the channeling implant process accelerates the shielding dopant toward the MOSFET device at an implant angle relative to a direction normal to a surface of the MOSFET device.

5. The method of the preceding claim, wherein the implant angle is between 3.5 degrees and 4.5 degrees.

6. The method of any of the preceding claims, further comprising:
forming a body contact region (330) having the second conductivity type within the semiconductor source region (304), wherein the body contact region is electrically coupled with the semiconductor body region (312).

7. The method of the preceding claim, wherein the body contact region is doped at a doping concentration greater than a semiconductor body concentration.

8. The method of any of the preceding claims, wherein the first conductivity type is an n-type semiconductor and the second conductivity type is a p-type semiconductor.

9. The method of any of the preceding claims, wherein the semiconductor epitaxial layer (310) is doped at a lower doping concentration than the semiconductor source region (304) .

10. The method of any of the preceding claims, wherein the semiconductor source region (304) is formed using an ion implantation process that intentionally damages a source region lattice structure during the ion implantation process.

11. The method of claim 6 or 7, wherein the body contact region (330) is formed using an ion implantation process that intentionally damages a body contact region lattice structure.

12. A trench-gate MOSFET device, comprising:
a semiconductor body region (312) having a first conductivity type;
a semiconductor source region (304) formed at a surface of the semiconductor body region and having a second conductivity type;
a semiconductor epitaxial layer (310) having the second conductivity type, wherein the semiconductor body region is separated from the semiconductor source region by the semiconductor body region;
a trench-gate opening (322a, 322b) etched from an exposed surface of the semiconductor source region, wherein the trench-gate opening comprises a bottom surface (340a, 340b) formed by the semiconductor epitaxial layer; and
a trench bottom protective region (350a, 350b) formed in the semiconductor epitaxial layer (310) at the bottom surface of the trench-gate opening (322a, 322b), wherein the trench bottom protective region comprises an implanted shielding dopant having the second conductivity type.
